Europäisches Patentamt

European Patent Office

Office européen des brevets

(19)

(11) Publication number: **0 132 596**
**A2**

(12) # EUROPEAN PATENT APPLICATION

(21) Application number: **84107210.1**

(22) Date of filing: **22.06.84**

(51) Int. Cl.⁴: **C 25 D 5/12**
**C 25 D 5/34, B 23 K 35/00**
**H 01 L 23/50**

(30) Priority: **25.06.83 JP 113659/83**

(43) Date of publication of application:
**13.02.85 Bulletin 85/7**

(84) Designated Contracting States:
**DE FR GB IT**

(71) Applicant: **Kobayashi, Masami**
**3-13-15, Hachimanyama**
**Setagaya-ku Tokyo(JP)**

(72) Inventor: **Kobayashi, Masami**
**3-13-15, Hachimanyama**
**Setagaya-ku Tokyo(JP)**

(74) Representative: **KUHNEN & WACKER**
**Patentanwaltsbüro**
**Schneggstrasse 3-5 Postfach 1729**
**D-8050 Freising(DE)**

(54) **Solderable nickel-iron alloy article and method for making same.**

(57) A nickel-iron alloy article having a solderability is obtained by electroplating a nickel-iron alloy material with nickel to an extent such that the resulting nickel-plated material exhibits a color tone intermediate between the color tone of the nickel-iron alloy and the color tone of nickel, and immediately thereafter, electro-plating the nickel-plated material with gold, silver or palladium, or an alloy thereof, to an extent such that the resulting plated material exhibits a color tone intermediate between the color tone of the nickel-plated material and the color tone of the gold, silver, palladium or alloy thereof used.

EP 0 132 596 A2

## SOLDERABLE NICKEL-IRON ALLOY ARTICLE
## AND METHOD FOR MAKING SAME

BACKGROUND OF THE INVENTION

(1) Field of the Invention

This invention relates to a solderable nickel-iron alloy article and a method for making the same.

Nickel-iron alloys including a 42 alloy comprised of 42% by weight of nickel and 57% by weight of iron have a low thermal expansion coefficient, and therefore, have hereinbefore been used incombination with glass as a part of a vacuum tube and are popularly used as a lead frame material for integrated circuits (IC). The lead frame material should possess good adhesion to chips, solderability, wire bondability and resin moldability.

(2) Description of the Prior Art

As means for imparting to the lead frame material adhesion to chips and wire bondability, the lead frame material is spot-plated with silver. However, the spot-plating of the lead frame material with silver is not simple and is costly. Furthermore, the lead frame material spot-plated with silver must be partly plated further with a solder in order to impart thereto solderability. This solder-plating procedure is also not simple.

SUMMARY OF THE INVENTION

It is therefore a primary object of the present invention to provide a nickel-iron alloy article which possess good adhesion to chips, solderability, wire bondability and resin moldability (i.e., capability of being molded with a resin), and which can be prepared by a simple plating procedure.

In one aspect of the present invention, there is provided a nickel-iron alloy article having a solderability, which comprises a thin plating layer of nickel formed on the surface of a nickel-iron alloy, and an ultra-thin plating layer of a metal selected from the group consisting of gold, silver and palladium, or an alloy selected from the group consisting of gold-, silver- or palladium-containing alloys, which is formed on the nickel plating layer, the amount of the nickel deposited being so small that a color tone intermediate between the color tone of the nickel-iron alloy and the color tone of nickel is produced when plated with nickel and the amount of the gold, silver or palladium or the alloy thereof deposited being so small that a color tone intermediate between the color tone of the nickel-plated nickel-iron alloy and the color tone of gold, silver or palladium or the alloy thereof, when plated with gold, silver or palladium or the alloy thereof.

In another aspect of the present invention, there is provided a method of making a nickel-iron alloy article having a solderability, which comprises:

electroplating a nickel-iron alloy material with nickel to an extent such that the resulting nickel-plated nickel-iron alloy material exhibits a color tone intermediate between the color tone of the nickel-iron alloy material and the color tone of nickel, and

immediately thereafter, electroplating the nickel-plated nickel-iron alloy material with a metal selected from the group consisting of gold, silver and palladium, and alloys of these metals, to an extent such that the resulting plated nickel-iron alloy material exhibits a color tone intermediate between the color tone of the nickel-plated nickel-iron alloy material and the color tone of the gold, silver, palladium or alloy thereof used.

DETAILED DESCRIPTION OF THE PREFERRED EMBODIMENTS

The method of making the solderable nickel-iron alloy article of the present invention will be described.

In the present invention, it is preferable that, prior to thin plating of nickel, alkali degreasing and activating treatments of the surface of nickel-iron alloy are carried out. The alkali degreasing treatment may be carried out according to the conventional method usig a commercially available alkali degreasing solution. According ot one preferred embodiment, nickel-iron alloy is dipped in a dilute solution of an alkali degreasing solution at an elevated temperature and electrolytic degreasing is then carried out in a dilute aqueous alkali solution.

After the alkali degreasing treatment, the nickel-iron alloy article is subjected to the activating treatment. It is preferred that this activating treatment be carried out in two stages. Namely, the activating treatment comprises the first step of dipping in an activating solution and the subsequent step of cathodic electrolysis in a cathodic electrolytic solution. This activating treatment will now be described.

The activating solution used in the first activating treatment is preferably an aqueous mixed acid solution containing, based on the weight of the solution:

      (i)   3 to 20% by weight of hydrochloric acid,

      (ii)   2 to 30% by weight of sulfuric acid,

      (iii)   0.1 to 5% by weight of a nonionic or cationic surface active agent and

      (iv)   0.1 to 20% by weight of 2-pyrrolidone or its N-alkyl derivative.

More preferably, the activating solution is an aqueous mixed acid solution containing, based on the weight of the solution:

      (i)   3 to 10% by weight of hydochloric acid,

      (ii)   0.5 to 4% by weight of nitric acid,

      (iii)   2 to 15% by weight of sulfuric acid,

      (iv)   1 to 5% by weight of acetic acid, (v)   3 to 10% by weight of citric acid,

      (vi)   0.1 to 3% by weight of a nonionic or cationic surface active agent,

(vii)   0.1 to 10% by weight of 2-pyrrolidone or its N-alkyl derivative and

(viii)   1 to 5% by weight of an acetylenic glycol.

If the amount of hydrochloric acid and sulfuric acid are too small, no substantial activating effect can be obtained, and if the amount of these acids are too large, over-pickling occurs.

If the amount of the nonionic or cationic surface active agent is smaller than 0.1% by weight, it is impossible to reduce the surface tension of the activating solution to the desired value, i.e., 30 dyne/cm or lower, and this surfactant need not be incorporated in an amount exceeding 5% by weight. The nonionic surface active agent used includes, for example, polyoxyethylene alkyl ethers such as polyoxyethylene alkyl ether. The cationic surface active agent includes, for example, perfluoroalkyl trimethylammonium salts. Among these surface active agents, nonionic surface active agents are preferable.

It is considered that 2-pyrrolidone or its N-alkyl derivative exerts a function of assuredly removing the passive state film and surface oxide dissolved in the mixed acid by virtue of excellent dissolving and washing powers thereof. It also exerts a function of assisting the acetylenic glycol's effect of preventing surface clouding. As the N-alkyl derivative of 2-pyrrolidone, those which have an alkyl group of 1 to 5 carbon atoms, are used. Preferable N-alkyl derivatives are N-ethyl-2-pyrrolidone and N-methyl-2-pyrrolidone.

The first activation treatment may be carried out by dipping the stainless steel in the activating solution at a normal temperature for 30 seconds to 7 minutes.

The activated nickel-iron alloys are then subjected to cathode electrolytic activation. The cathode electrolytic activation solution used in this step is preferably an aqueous mixed acid solution containing, based on the weight of the solution:

(i)    5 to 20% by weight of phosphoric acid,

(ii)   2 to 10% by weight of nitric acid,

(iii)  0.1 to 5% by weight of a nonionic surface active agent and

(iv)   0.1 to 20% by weight of 2-pyrrolidone or its N-alkyl derivative.

More preferably, the solution used in the cathode electrolytic activation step is an aqueous mixed acid solution containing, based on weight of the solution:

(i)    5 to 10% by weight of phosphoric acid,

(ii)   2 to 10% by weight of citric acid,

(iii)  1 to 5% by weight of oxalic acid,

(iv)   2 to 5% by weight of nitric acid,

(v)    3 to 20%, especially 3 to 10%, by weight of sulfuric acid,

(vi)   0.1 to 3% by weight of a nonionic or cationic surface active agent,

(vii)  0.5 to 10%, especially 0.5 to 5%, by weight of gluconic acid,

(viii) 0.1 to 10% by weight of 2-pyrrolidone or its N-alkyl derivative and

(ix)   1 to 5% by weight of an acetylenic glycol.

If the amount of phosphoric acid is smaller than 5% by weight, no substantial cathode electrolytic activating effect can be attained, and if the amount of phosphoric acid exceed 20% by weight, no substantial increase of the effect can be obtained. If the amount of nitric acid is smaller than 2% by weight, the cathode electrolytic activating effect is low, and if nitric acid is incorporated in an amount exceeding 10% by volume, there arises a risk of plating failure.

When the amount of the nonionic or cationic surface active agent is smaller than 0.1% by weight, it is impossible to reduce the surface tension of the cathode electrolytic activating solution to the desired value, i.e., 30 dyne/cm or lower, and it is not necessary to use the surfactant in an amount exceeding 5% by weight. The nonionic surface active agents and the cationic surface active agents used include those which are hereinbefore mentioned with respect to the activating solution used in the first activating step. In general, the nonionic surface active agents are more preferable than the cationic surface active agents.

If the amount of 2-pyrrolidone or its N-alkyl derivative is smaller than 0.1% by weight, the washing effect and the effect of preventing clouding by an acetylenic glycol cannot be attained, and if the amount of 2-pyrrolidone or its N-alkyl derivative is larger than 20% by weight, a large quantity of heat is generated at the time of incorporation and 2-pyrrolidone or its N-alkyl derivative is wastefully consumed. As the N-alkyl derivative of 2-pyrrolidone, those which have an alkyl group of 1 to 5 carbon atoms, are used. Preferable N-alkyl derivatives are N-ethyl-2-pyrrolidone and N-methyl-2-pyrrolidone.

At the cathode electrolytic activation step, electrolysis may be carried out at a normal temperature at a cathode current density of 1 to 7 $A/dm^2$ for 30 seconds to 5 minutes by using a platinum-coated titanium anode and the nickel-iron alloy as the cathode.

The nickel-iron alloy which has been subjected to the activating treatment is then subjected to nickel plating. This nickel platig is performed according to the conventional electrolytic plating method using nickel salts such as nickel sulfate, nickel sulfamate and nickel chloride.

The nickel electroplating may be carried out at a temperature of 45° to 65°C in an elctroplatig solution at a cathode current density of 4 to 12 $A/dm^2$ for 10 seconds to 2 minutes by using the nickel-iron alloy as the cathode and a nickel plate as the anode.

In the present invention, the amount of the nickel deposited is important. Namely, the amount of the nickel is so small that a color tone intermediate between the color tone before plating and the color tone of nickel is produced on the surface. Supposing that a uniform film of nickel is formed by plating (actually, no uniform film is formed because the amount of the nickel deposited is very small), the amount of nickel is ordinarily controlled so that a film having a thickness of 100 to 1,000 $\overset{o}{A}$, preferably 300 to 700 $\overset{o}{A}$, most preferably about 500 $\overset{o}{A}$, is formed.

The nickel-plated nickel-ion alloy is immediately electroplated with gold, silver or palladium or an alloy thereof. The electroplating procedure may be conventional. Usually, the electroplating is carried out at a temperature of 40° to 65°C at a cathode current density of 0.5 to 18 A/dm$^2$ for one second to two minutes by using the nickel-iron alloy as the cathode and a nickel plate as the anode. The electroplating of gold may be carried out preferably by using an electroplating solution containing about 100 g/l of citric acid, about 100 g/l of sodium citrate, about 20 g/l of nickel sulfamate and about 5 g/l of potassium gold cyanide and maintained at 40°C.

The amount deposited of gold, silver, palladium or an alloy thereof is important in the present invention. Namely, the amount deposited is so small that a color tone intermediate between the color tone before plating and the color tone of gold, silver, palladium or an alloy thereof is produced on the plated surface. Supposing that a uniform film of the metal or alloy is formed by plating, the amount deposited is controlled so that the thickness of the gold or palladium film is 30 to 500 $\overset{o}{A}$, preferably 50 to 300 $\overset{o}{A}$ and the thickness of the silver film is 50 to 2,000 $\overset{o}{A}$, preferably 100 to 1,000 $\overset{o}{A}$ (actually, no uniform film is formed but the metal or alloy is deposited in the form of spots).

The nickel-iron alloy used in the present invention preferably consists essentially of 6 to 45% by weight of nickel and 55 to 94% by weight of iron. A typical example of the nicle-iron alloy is a 42 alloy composed of 42% by weight of nickel and 57% by weight of iron, and minor amounts fo manganese and silicon. Usually, the nickel-iron alloy contains minor amounts of manganese, silicon and other element for example, 0.5% by weight of manganese, 0.3% by weight of silicon and trace amounts of sulfur, phosphorus and carbon).

The nickel-iron alloy article of the present invention exhibits good affinity with a molten sulfur and thus good solderability. It is presumed that this good solderability is due to the fact that, in the nickel plating step, nickel is selectively bonded with the nickel exposed on the nickel-iron alloy to form an activated nickel site, and, in the succeeding plating step with gold, silver, palladium or alloys thereof, gold, silver, palladium or an alloy thereof is bonded to the activated nickel site to form an alloy (A), which prevents oxidation of the nickel. When the thus obtained nickel-iron alloy is subjected to soldering, the solder readily forms an alloy together with the above-mentioned alloy (A).

A product obtained by subjecting a nickel-iron alloy material for an electronic part, for example, a nickel-iron alloy band punched into a shape of a lead frame for IC, to the above-mentioned plating treatment, can be soldered very easily and tightly. Moreover, this product is advantageous in that the adaptability to the soldering operation is improved and the wire bondability is enhanced. Since a material customarily used for a lead frame for IC, for example, a copper alloy, is very excellent in the heat conductivity, the soldering heat is promptly absorbed and diffused in the interior of the material at the soldering operation and the initial wettability of the solder to the surface of the copper alloy is low. Accordingly, in order to obtain good soldering, it is necessary to wait a considerable time before the temperature of the portion to be soldered is elevated to the same level as the temperature of the solder, and it is impossible to complete the soldering operation in a short time.

In contrast, soldering of the nickel-iron alloy article of the present invention is accomplished in a very short time with a good wettability.

In the conventional materials for lead frames for IC, thick plating of gold, silver, tin or tin-antimony or paste baking of gold or silver is applied to the surface so as to provide a surface on which high-speed bonding is possible. In case of the lead frame for IC according to the present invention, at the wire-bonding operation, according to the same principle as the above-mentioned principle of the soldering operation, the heat of a minute amount of the molten top of an ultra-fine gold wire to be bonded is not lost by absorption ·or diffusion into the base material and solidification of molten gold is prevented, and therefore, bonding is accomplished in a very short time.

The present invention will now be described in detail with reference to the following examples that by no means limit the scope of the invention.

Example 1

A hoop material of a 42 alloy comprised of 57% by weight of iron and 42% by weight of nickel punched into a lead frame shape having a thickness of 0.25 mm, a width of 25.14 mm and a length of 800 m was passed through the following step (1) through (5) and was subjected to nickel plating and ultra-thin gold plating.

(1) Alkali Degreasing Step

A commercially available alkali degreasing solution was heated at 70 to 80°C in a stainless steel tank, and the 42 alloy lead frame material was passed through this tank in succession to effect primary degreasing. Then, in an aqueous alkali solution maintained at 40 to 60°C, direct current electrolytic degreasing was carried out by using a stainless steel plate as the anode and the 42 alloy lead frame material as the cathode and applying a voltage of 6 volts.

(2)  First Activating Step

Then, the 42 alloy lead frame material was passed through a bath formed by adding 0.2% by weight of a polyethylene glycol alkyl ether (a nonionic surface active agent), 3% by weight of N-ethyl-2-pyrrolidone and 0.1% by weight of an amine type anti-corrosive agent to a mixed acid comprising 20% by volume of hydrochloric acid (35% solution), 10% by volume of sulfuric acid (85% solution), 10% by weight of citric acid (powder), 1% by volume of acetic acid (90% solution) and 5% by volume of nitric acid (68% solution) to remove oxides and impurities on the surface of the lead frame material.

(3)  Electrolytic Activating Step

A bath formed by adding 0.2% by weight of the same nonionic surface active agent as mentioned above, 5% by weight of N-ethyl-2-pyrrolidone and 0.1% by weight of the same anti-corrosive agent to a mixed acid comprising 10% by volume of phosphoric acid (85% solution), 10% by volume of sulfuric acid (85% solution), 5% by volume of citric acid (powder), 8% by volume of nitric acid (68% solution) and 1% by volume of acetic acid (90% solution) was heated at 60°C, and while using the lead frame material as the cathode and a platinum-deposited titanium plate as the anode, and applying a voltage of 4 volts, the stainless steel lead frame material was passed through the bath to activate the surface of the lead frame material.

(4)  Nickel Plating Step

The temperature of a plating solution comprising 300 g/l of nickel sulfate, 40 g/l of nickel chloride and 30 g/l of boric acid was maintained at 50°C, and electroplating was carried out for 15 seconds at a current density of 6 A/dm$^2$ by using the lead frame material as the cathode and a nickel plate as the above.

As the result, a nickel plating a layer having a thickness of about 500 Å was formed on both the sides of the 42 alloy hoop. Incidentally, this thickness of 500 Å of the nickel plating layer was not a measured value but a mean value obtained by dividing the amount of the nickel deposited by the area. When the plated surface was examined with the naked eye, it was found that a color tone intermediate between the color tone of the 42 alloy and the color tone of nickel was produced on the surface.

(5) Gold Plating Step

The temperature of a plating solution comprising 120 g/l of citric acid, 120 g/l of sodium citrate, 30 g/l of nickel sulfamate and 8 g/l of gold potassium cyanide was maintained at 35°C, and gold plating was carried out for 2 seconds at a current density of 3 to 10 A/dm$^2$ by using the lead frame material as the cathode and a platinum-deposited titanium plate as the anode.

As the result, a gold plating layer having a thickness of 70 Å was formed on both the sides of the lead frame material, whereby a 42 alloy lead frame material of the present invention was obtained. Incidentally, the thickness of 70 Å of the gold plating layer was not a measured value but a mean value obtained by dividing amount of the gold deposited by the area. When the surface was examined with the naked eye, it was found that a color tone intermediate between the color tone of the nickel-plated 42 alloy and the color tone of gold was produced on the surface.

Example 2

A hoop material of 42 alloy (42% Ni, 57% Fe) punched into a shape having a thickness of 0.25 mm, a width of 25.14 mm and a length of 700 m was passed through the following steps (1) through (5) and was continuously subjected to nickel electroplating and immediately to ultra-thin gold electroplating.

The alkali degreasing step (1), first activating step (2), electrolytic activating step (3) and nickel plating step (4) were carried out in the same manner as described in Example 1.

(5)  Gold Plating Step

Electroplating was carried out in a plating solution comprising 120 g/l of citric acid, 120 g/l of sodium citrate, 30 g/l of nickel sulfamate and 8 g/l of gold potassium cyanide, maintained at 35°C, for 3 seconds at a current density of 5 to 10 A/dm$^2$ by using the hoop lead frame as the cathode and a platinum-plated titanium plate as the anode.  During the electroplating, the hoop lead frame was slided on a silicone rubber plate provided in the plating solution whereby a gold plating layer was formed only one side of the hoop lead frame.

As the result, a hoop lead frame having a gold plating layer having a thickness of 70 Å on one side thereof was obtained.  The thickness of 70 Å of the gold plating layer was not a measured value but a mean value obtained by dividing the amount of the gold deposited by the area.  When the surface was examined with the naked eye, it was found that a color tone intermediate between the color tone of the nickel-plated hoop material and the color tone of gold was produced on the surface.

Example 3

A lead frame material of 42 alloy (42% Ni, 57% Fe) punched into a shape having a thickness of 0.25 mm, a width of 36 mm and a length of 500 m was passed through the following steps (1) through (4) immediately to ultra-thin silver electroplating.

The alkali degreasing step (1), first activating step (2), electrolytic activating step (3) and nickel plating step (4) were carried out in the same manner as described in Example 1.

(5)   Silver Plating Step

The temperature of a plating solution comprising 3% by weight of silver cyanide, 15% by weight of copper cyanide and 60% by weight of potassium cyanide was maintained at 30°C, and electroplating was carried out for 3 seconds at a current density of 10 A/dm$^2$ by using the 42 alloy lead frame as the cathode and a silver plate as the anode.

Example 4

A lead frame material of 42 alloy (42% Ni, 57% Fe) having a thickness of 0.25 mm, a width of 26 mm and a length of 700 m was passed through the following steps (1) through (3) and was then subjected to nickel electroplating and immediately to ultra-thin palladium plating.

The alkali degreasing step (1), first activating step (2), electrolytic activating step (3) and nickel plating step (4) were carried out in the same manner as described in Example 1.

(5)   Palladium Plating Step

The temperature of a neutral plating solution containing the palladium component in an amount of 15 g/l as the metal was maintained at 45°C, and plating was carried out at a current density of 5 A/dm$^2$ for 3 seconds by using a platinum-deposited titanium plate as the anode and the 42 alloy lead frame as the cathode.

As the result, a palladium plating layer having a thickness of 70 Å was formed on the surface of the 42 alloy lead frame material, whereby a lead frame of the present invention was obtained.  The thickness of 70 Å of the palladium plating layer was not a measured value but a mean value obtained by dividing the amount deposited of palladium by the area.  When the plated surface was examined with the naked eye, it was found that a color tone intermediate between the color tone of the nickel-plated 42 alloy and the color tone of palladium was produced on the surface.

Example 5

A lead frame material of an alloy comprised of 38% by weight of nickel and 61% by weight of iron having a thickness of 0.25 mm, a width of 21 mm and a length of 800 m was passed through the following steps (1) through (3) and was then subjected to nickel plating and immediately to ultra-thin palladium-nickel alloy plating.

The alkali degreasing step (1), first activating step (2), electrolytic activating step (3) and nickel plating step (4) were carried out in the same manner as described in Example 1.

(5) Palladium-nickel Plating Step

In a neutral solution containing 8% by weight of sulfamic acid, 20 g/l as the metal of the palladium component and 10 g/l as the metal of the nickel component, Pd-Ni alloy plating was carried out at a current density of 8 to 6 $A/dm^2$ at a plating solution temperature of 40°C for 2 seconds by using the Ni-Fe alloy lead frame material as the cathode and a platinum-deposited titanium plate as the anode.

As the result, a Pd-Ni alloy plating layer having a thickness of about 100 Å was formed on the surface of the Ni-Fe alloy, whereby a Ni-Fe alloy lead frame material of the present invention was obtained. The thickness of 100 Å of the plating layer was not a measured value but a mean value obtained by dividing the amount deposited of the Pd-Ni alloy by the area. When the plated surface was examined with the naked eye, it was found that a color tone intermediate between the color tone of the nickel-plated Ni-Fe alloy and the color tone of the Pd-Ni alloy was produced on the surface.

The physical and chemical properties of the Ni-Fe lead frames for IC prepared in Examples 1 through 5 were tested according to the following procedures.

(1) Physical Properties

(i) Cross-Cut Peeling Test

Square cuts having a size of 1 mm x 1 mm were formed by a cutter on the lead frame material of 42-alloy plated with nickel and then gold, palladium or silver according to the present invention, and an adhesive tape was applied to the cut surface and the peeling test was carried out. Peeling of gold, palladium or silver, and nickel was not observed.

(ii) Bending Test

The above-mentioned sample was bent by 180° and the peeling test was carried out by using an adhesive tape. Peeling of gold, palladium or silver, and nickel was not observed. This bending test was repeated to break the sample. Peeling of Au, Pd or Ag and Ni was not observed on the broken face.

(2) Chemical Properties

(i) High-Temperature High-Humidity Test

The lead frame material of 42 alloy ultra-thinly plated with nickel and thin gold, palladium or silver according to the present invention was placed for 7 days in an atmosphere maintained at a relative humidity of 98% and a temperature of 65°C according to the standards of MIL-STD-202D-106C. Then, the solderability and wire bondability were tested. It was found that the solderability or the wire bondability was not degraded at all, and good results were obtained.

(ii) Thermal Shock Test

The lead frame material of 42 alloy ultra-thinly plated with nickel and then gold, palladium or silver according to the present invention was subjected 5 times repeatedly to the heat treatment cycle of +85°C for 30 minutes and -15°C for 30 minutes, and the solderability and wire bondability were tested. The solderability and wire bondability after the heat treatment were the same as those before the heat treatment.

The solderability of each of the above-mentioned 42 alloy lead frames was tested according to the following procedures.

(1) Soldering Test

The lead frame of 42 alloy ultra-thinly plated with nickel and then gold, palladium, silver or palladium-nickel was set at a tester, and wetting with solder was electrically detected. The repulsion phenomenon by the surface tension of the solder at the initial stage of dipping was greatly controlled and very good wetting was found. The solderability was higher than the solderability to phosphor bronze tested under the same conditions.

(2) Test in Soldering Tank

Solder comprising tin and lead at a ratio of 6/4 was fused in a soldering tank and the temperature of the melt was maintained at 230°C. Each of lead frame materials of 42 alloy and 38 Ni-61 Fe alloy ultra-thinly plated with nickel and then gold, silver or palladium, which had been subjected to surface washing with trichloroethane, was soldered in the flux-free state for a dipping time of 3 or 5 seconds. In each case, a good solderability was observed and a solder deposition higher than 95% was obtained.

(3) Test Using Electric Soldering Iron

Each of the three lead frame materials of 42 alloy thinly plated with nickel and then gold, silver or palladium according to the present invention was soldered to a 0.2 mm-diameter wire of 38% Ni-61% Fe alloy ultra-thinly plated with nickel and then gold by using a commercially available electric soldering iron and a linear resin-incorporated solder (tin/lead = 6/4). Excellent solderability and bondability were observed. Thus, it was confirmed that soldering of Ni-Fe alloys differing in the composition could be accomplished advantageously.

(4) Bonding Strength Test

A gold wire having a diameter of 30 μm was

bonded to the surface of the plated 42 alloy lead frame material of the present invention by using a high speed bonding machine. The bonding strength of the gold wire bonded to the above lead frame material was 7 g on the average. It was confirmed that the above lead frame material could be advantageously used for a lead frame for IC.

CLAIMS

1. A nickel-iron alloy article having a solderability, which comprises a thin plating layer of nickel formed on the surface of a nickel-iron alloy, and an ultra-thin plating layer of a metal selected from the group consisting of gold, silver and palladium, or an alloy selected from the group consisting of gold-, silver- or palladium-containing alloys, which is formed on the nickel plating layer, the amount of the nickel deposited being so small that a color tone intermediate between the color tone of the nickel-iron alloy and the color tone of nickel is produced when plate with nickel and the amount of the gold, silver or palladium or the alloy thereof deposited being so small that a color tone intermediate between the color tone of the nickel-plated nickel-iron alloy and the color tone of gold, silver or palladium or the alloy thereof, when plated with gold, silver or palladium or the alloy thereof.

2. A nickel-iron alloy article according to claim 1, wherein the nickel-iron alloy consists essentially of 6 to 45% by weight of nickel and 55 to 94% by weight of iron.

3. A nickel-iron alloy article according to claim 1, wherein the amount of the deposited nickel is 500 $\overset{o}{A}$ as expressed in terms of thickness which is calculated by dividing the amount of the deposited nickel by the area.

4. A nickel-iron alloy article according to claim 1, wherein the amount of the deposited nickel is in the range of 300 to 700 $\overset{o}{A}$ as expressed in terms of thickness which is calculated by dividing the amount of the deposited nickel by the area.

5. A nickel-iron alloy aritcle according to claim 1, wherein the amount of the deposited gold, plalladium or alloy thereof is in the range of 30 to 500 $\overset{o}{A}$ as expressed in terms of thickness which is calculated by dividing the amount of the deposited gold, palladium or alloy thereof by the area.

6.    A nickel-iron alloy article according to claim 1, wherein the amount of the deposited gold, palladium or alloy thereof is in the range of 50 to 300 $\overset{\circ}{A}$ as expressed in terms of thickness which is calculated by dividing the amount of the deposited gold, palladium or alloy thereof by the area.

7.    A nickel-iron alloy article according to claim 1, wherein the amount of the deposited silver or alloy thereof deposited is in the range of 50 to 2,000 $\overset{\circ}{A}$ as expressed in terms of thickness which is calculated by dividing the amount of the deposited silver or alloy thereof by the area.

8.    A nickel-iron alloy article according to claim 1, wherein the amount of the deposited silver or alloy thereof is in the range of 100 to 1,000 $\overset{\circ}{A}$ as expressed in terms of thickness which is calculated by dividing the amount of the deposited silver or alloy thereof by the area.

9.    A nickel-iron alloy article according to claim 1, which is a lead frame for IC.

10.    A method of making a nickel-iron alloy article having a solderability, which comprises:

electroplating a nickel-iron alloy material with nickel to an extent such that the resulting nickel-plated nickel-iron alloy material exhibits a color tone intermediate between the color tone of the nickel-iron alloy material and the color tone of nickel, and

immediately thereafter, electroplating the nickel-plated nickel-iron alloy material with a metal selected from the group consisting of gold, silver and palladium, and alloys of these metals, to an extent such that the resulting plated nickel-iron alloy material exhibits a color tone intermediate between the color tone of the nickel-plated nickel-iron alloy material and the color tone of the gold, silver, palladium or alloy thereof used.

11. A method according to claim 10, wherein the nickel-iron alloy material consists essentially of 6 to 45% by weight of nickel and 55 to 94% by weight of iron.

12. A method according to claim 10, wherein the amount of the deposited nickel is 500 $\overset{o}{A}$ as expressed in terms of thickness which is calculated by dividing the amount of the deposited nickel by the area.

13. A method according to claim 10, wherein the amount of the deposited nickel is in the range of 300 to 700 $\overset{o}{A}$ as expressed in terms of thickness which is calculated by dividing the amount of the deposited nickel by the area.

14. A method according to claim 10, wherein the electroplating with nickel is carried out at a temperature of 45 to 65°C at a cathode current density of 4 to 12 ampere/dm$^2$ for a period of 10 seconds to 2 minutes.

15. A method according to claim 10, wherein the amount of the deposited gold, palladium or alloy thereof is in the range of 30 to 500 $\overset{o}{A}$ as expressed in terms of thickness which is calculated by dividing the amount of the deposited gold, palladium or alloy thereof by the area.

16. A method according to claim 10, wherein the amount of the deposited gold, palladium or alloy thereof is in the range of 50 to 300 $\overset{o}{A}$ as expressed in terms of thickness which is calculated by dividing the amount of the deposited gold, palladium or alloy thereof by the area.

17. A method according to claim 10, wherein the amount of the deposited silver or alloy thereof deposited is in the range of 50 to 2,000 $\overset{o}{A}$ as expressed in terms of thickness which is calculated by dividing the amount of the deposited silver or alloy thereof by the area.

- 4 -    0132596

18.    A method according to claim 10, wherein the amount of the deposited silver or alloy thereof is in the range of 100 to 1,000 $\overset{o}{A}$ as expressed in terms of thickness which is calculated by dividing the amount of the deposited silver or alloy thereof by the area.

19.    A method according to claim 10, wherein the electroplating with gold, silver, palladium or an alloy thereof is carried out at a temperature of 40 to 65°C at a cathode current density of 0.5 to 18 ampere/dm$^2$ for a period of 1 second to 2 minutes.

20.    A method according to claim 10, wherein, prior to the electroplating with nickel, the nickel-iron alloy material is dipped in an activating solution containing, based on the weight of the solution:

(i)    3 to 20% by weight of hydrochloric acid,

(ii)    2 to 30% by weight of sulfuric acid,

(iii)    0.1 to 5% by weight of a nonionic or cationic surface active agent and

(iv)    0.1 to 20% by weight of 2-pyrrolidone or its N-alkyl derivative, and then, the activated nickel-iron alloy material is subjected to cathodic electrolysis in a cathode electrolytic activation solution containing, based on the weight of the solution:

(i)    5 to 20% by weight of phosphoric acid,

(ii)    2 to 10% by weight of nitric acid,

(iii)    0.1 to 5% by weight of a nonionic surface active agent and

(iv)    0.1 to 20% by weight of 2-pyrrolidone or its N-alkyl derivative.

21.    A method according to claim 10, wherein the nickel-iron alloy article is a lead frame for IC.